# EUROPÄISCHE PATENTANMELDUNG

(11) **EP 1 298 547 A1**
(43) Veröffentlichungstag der Anmeldung: **02.04.2003**
(21) Anmeldenummer: 02017904.0
(22) Anmeldetag: 09.08.2002
(51) Int. Cl.: G06F 17/50

(54) **Verfahren zur Entwicklung eines komplexen Fahrzeuges**

(30) Priorität: 26.09.2001 DE 10147558
(71) Anmelder: Rheinmetall Landsysteme GmbH, 24159 Kiel (DE)
(72) Erfinder: Diller, Armin, Dipl.-Ing., 86199 Augsburg (DE)
(74) Vertreter: Dietrich, Barbara

(57) **Zusammenfassung**

Es wird ein Verfahren bei der Entwicklung vorgeschlagen, bei dem ein parametrisierter Entwicklungsträger das CAD-Modell eines Gesamtsystems, zum Beispiel eines Fahrzeugs, darstellt und Änderungen sehr flexibel mittels der Parametrisierung in die Entwicklung eingebracht werden können.

## Beschreibung

Die Erfindung bezieht sich auf die Entwicklung eines komplexen Gegenstands wie zum Beispiel eines Fahrzeugs, bei dem eine Vielzahl von Änderungen im Laufe des Entwicklungszeitraums vorkommen und einfliessen. Gerade auch bei wehrtechnischen Systemen unterliegen die Entwicklungen einer Vielzahl von Änderungen von der anfänglichen Konzeptphase bis zur Kontruktionsreife oder sogar bis zur Produktion. Diese Änderungen sind bedingt durch verschiedene Lösungsansätze, welche gemäß dem Grad ihrer jeweiligen Aufgabenerfüllung gefiltert werden müssen, sowie durch im Verlauf der Entwicklungszeit weiter spezifizierte Anforderungen an das zu entwickelnde System, sowie auch durch die Einbindung neuer Technologien, welche erst im Verlauf des Projekts die Anwendungsreife erreichen. Die Entwicklung eines solchen Systems sollte deshalb hochflexibel erfolgen, um am Ende zu einem optimalen Ergebnis zu gelangen.

Nach dem Stand der Technik bedingt eine schnelle und kostengünstige Entwicklung von Systemen die optimale Ausnutzung von Informationstechnologie. Dazu wird bereits in einer sehr frühen Entwicklungsphase damit begonnen, erste Konzepte zum Entwicklungsgegenstand mittels CAD zu modellieren. Diese Modelle dienen neben dem Systemdesign auch der ständigen Kontrolle der Realisierbarkeit, was verschiedene Analysen wie zum Beispiel Berechnungen zur Festigkeit oder Simulationen mit einschliesst. Plausibel ist, dass diese frühen Modelle noch ständigen Änderungen unterliegen. Modell-Modifikationen sollten deshalb schnell und damit kostengünstig eingebracht werden können.

Generell kann die Erzeugung eines CAD-Modells auf verschiedene Arten erfolgen.

Die explizite Modellierung ist eine nicht-parametrische Modellierung. Objekte werden im Verhältnis zur Modellgröße und nicht im Verhältnis zur gegenseitigen Größe erzeugt. Änderungen, die an einem oder mehreren Objekten vorgenommen werden, wirken sich nicht notwendigerweise auf andere Objekte oder auf das fertige Modell aus. Das Erzeugen einer Linie zwischen zwei vorhandenen Punkten oder das Erzeugen eines Bogens durch drei vorhandene Punkte sind Beipiele für die explizite Modellierung. Wenn einer der vorhandenen Punkte verschoben wird, ändert sich hierdurch die Linie oder der Bogen nicht.

Selbst bei einfachen CAD-Modellen, die in der Konzeptphase einen geringen Detaillierungsgrad aufweisen, ist es nachteilig, dass Modifikationen dennoch aufwendig und zeitintensiv sind.

Bei einem Parametrischen Modell werden die für die Definition des Modells verwendeten Werte (Parameter) mit dem Modell für die zukünftige Bearbeitung gespeichert. Durch gegenseitige Referenzen zwischen den Parametern können Verhältnisse zwischen den Parametern hergestellt werden. Durchmesser und Tiefe einer Bohrung oder die Länge, Breite und Höhe eines Rechteck-Polsters sind hierfür entsprechende Beispiele. Ein Entwickler möchte beispielsweise, dass die Tiefe der Bohrung stets mit der Höhe des Polsters übereinstimmt. Dies lässt sich mit entsprechender Verknüpfung der Parameter erreichen, was in einem expliziten Modell nicht ohne weiteres durchführbar ist. Dieses Prinzip der Parametrisierung beschränkt sich bisher auf die Modellierung von Normteilen oder anderen einfachen Bauteilen.

Bei einer Modellierung mit Randbedingungen wird die Geometrie über eine Gruppe von Richtlinien bestimmt, die wiederum auf die Geometrie angewendet werden, die die Modellierung als Randbedingungen definiert. Bei diesen Randbedingungen kann es sich um Randbedingungen für Bemassung, wie zum Beispiel Skizzenbemassung oder Positionierungsbemassung, oder um geometrische Randbedingungen, wie zum Beispiel Parallelität- oder Tangential-Randbedingungen handeln. Beispielweise tangiert eine Linie einen Kreisbogen und der Entwickler möchte, dass die Tangentialbedingung auch dann erhalten bleibt, wenn sich der Winkel der Linie ändert, oder dass eine Senkrechtenbedingung auch dann erhalten bleibt, wenn die Winkel modifiziert werden.

CAD-Modelle müssen nicht zwangsläufig entsprechend nur einer dieser drei Methoden modelliert werden. Im Rahmen zulässiger und sinnvoller Mischung lassen sich diese Methoden auch innerhalb eines Modells kombinieren, was jedoch die Übersichtlichkeit oft stark beeinträchtigt.

Nach dem Stand der Technik werden komplexe Systeme, wie zum Beispiel militärische Fahrzeuge, expliziert modelliert, wobei vereinzelt parametrisierte Einzelteile oder Kleinbaugruppen zu finden sind, die jedoch untereinander in keiner Beziehung stehen. Änderungen am Modell erfordern deshalb ein Höchstmass an Kenntnis des Gesamtsystems, um alle entstehenden Auswirkungenzu erkennen und dementsprechend mit großem zeitlichen Aufwand reagieren zu können.

Aufgabe der Erfindung ist es, ein Verfahren anzugeben, bei dem für die Entwicklung eines Gegenstands ein CAD-Modell (Computer-Aided-Design) zur Verfügung gestellt wird, welches dynamisch allen einzubringenden Änderungen folgt, damit die Entwicklungszeit reduziert bzw. nicht erhöht wird.

Diese Aufgabe wird erfindungsgemäß durch die kennzeichnenden Merkmale des Anspruchs 1 gelöst. Weitere Merkmale ergeben sich aus den Unteransprüchen.

Erfindungsgemäß wird ein CAD-Modell durch einen parametrisierten Entwicklungsträger realisiert. Dazu wird das CAD-Modell eines Gesamtsystems, zum Beispiel Panzerturm und/oder Fahrzeug, vollständig parametrisiert aufgebaut. Die geometrischen Daten des Entwicklungsträgers sind in einer Tabelle hinterlegt und können somit unter gleichzeitiger Modifikation aller verknüpfter Werte schnell geändert werden.

Die Vorteile der Erfindung liegen darin, dass Änderungen an dem parametrisierten Modell schnell vorgenommen werden können, wobei der Nachteil, dass die Erstellung eines solchen Modells mehr Zeit als eine herkömmliche Modellierung benötigt, durch die Vorteile in der Regel aufgewogen werden kann bei einem komplexen Entwicklungsgegenstand. Dabei ist auch vorstellbar, dass eine Modellbibliothek mit verschiedenen parametrisierten Turmoder Fahrzeugtypen erstellt werden kann, um schnell und aussagekräftig auf Kundenwünsche reagieren zu können. Die Einbringung von Änderungen wird vereinfacht und erleichtert.

## Patentansprüche

1. Verfahren zur Entwicklung eines komplexen Fahrzeugs oder Teilsystems eines Fahrzeugs unter Verwendung eines CAD-Datensystems für die Erzeugung von Modellen aller Art und für die Konstruktion von Teilen
**dadurch gekennzeichnet,**
**dass** das geometrische oder sonstige CAD-Modell eines zu entwickelnden Gesamtsystems parametrisiert als parametrisierter Entwicklungsträger hergestellt wird und Änderungen am Gesamtsystem über Änderungen an den Parametern in das Modell eingebracht werden können.

2. Verfahren nach Anspruch 1
**dadurch gekennzeichnet,**
**dass** zusätzlich zu der reinen Parametrisierung bei der Modellerzeugung mit Randbedingungen wie zum Beispiel Parallelität oder Tangentialität gearbeitet werden kann.

3. Verfahren nach Anspruch 1
**dadurch gekennzeichnet,**
**dass** die geometrischen Daten des parametrisierten Entwicklungsträgers in einer Tabelle hinterlegt sind und geändert werden können.

4. Verfahren nach einem der oben genannten Ansprüche
**dadurch gekennzeichnet,**
**dass** im parametrisierten Modell vereinzelt kleine explizite Untergruppen vorhanden sein können, welche jedoch untereinander wieder in Beziehung stehen.
